(19) Europäisches Patentamt
European Patent Office
Office européen des brevets

(11) **EP 4 143 586 B1**

(12) **EUROPÄISCHE PATENTSCHRIFT**

(45) Veröffentlichungstag und Bekanntmachung des Hinweises auf die Patenterteilung:
**17.09.2025 Patentblatt 2025/38**

(21) Anmeldenummer: **21703888.4**

(22) Anmeldetag: **05.02.2021**

(51) Internationale Patentklassifikation (IPC):
*G01R 1/20* *(2006.01)* *G01R 19/00* *(2006.01)*

(52) Gemeinsame Patentklassifikation (CPC):
**G01R 1/203**

(86) Internationale Anmeldenummer:
**PCT/EP2021/052737**

(87) Internationale Veröffentlichungsnummer:
**WO 2021/219263 (04.11.2021 Gazette 2021/44)**

(54) **STROMMESSWIDERSTAND**

CURRENT-SENSING RESISTOR

RÉSISTANCE DE MESURE DE COURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.04.2020 DE 102020111634**

(43) Veröffentlichungstag der Anmeldung:
**08.03.2023 Patentblatt 2023/10**

(73) Patentinhaber: **Isabellenhütte Heusler GmbH & Co. KG**
**35683 Dillenburg (DE)**

(72) Erfinder:
• **KRAMM, Benedikt**
**35435 Wettenberg (DE)**
• **LEBEAU, Felix**
**35745 Herborn (DE)**
• **THOMAS, Sven**
**35708 Haiger (DE)**

(74) Vertreter: **v. Bezold & Partner Patentanwälte - PartG mbB**
**Ridlerstraße 57**
**80339 München (DE)**

(56) Entgegenhaltungen:
WO-A1-2012/019784    DE-A1- 102013 005 939
US-A1- 2016 077 135

**Beschreibung**

Die Erfindung betrifft einen Strommesswiderstand zur Messung eines elektrischen Stroms gemäß der Vierleitertechnik.

Ein derartiger Strommesswiderstand ist grundsätzlich aus WO 2012/019784 A1 bekannt. Dieser bekannte Strommesswiderstand besteht im Wesentlichen aus einem plattenförmigen Widerstandselement aus einer Widerstandslegierung (z.B. Manganin®) und zwei ebenfalls plattenförmigen Anschlussteilen aus einem Leitermaterial (z.B. Kupfer), wobei die beiden Anschlussteile auf gegenüberliegenden Seiten des Widerstandselements mit dem Widerstandselement verschweißt sind. Der zu messende elektrische Strom wird über die beiden Anschlussteile in den Strommesswiderstand eingeleitet bzw. aus dem Strommesswiderstand abgeleitet, so dass der zu messende elektrische Strom durch das Widerstandselement des Strommesswiderstands fließt. In den beiden Anschlussteilen sind an den Grenzen zu dem Widerstandselement zwei Spannungsmesskontakte angebracht, um den Spannungsabfall über dem Widerstandselement zu messen. Der gemessene Spannungsabfall entspricht dann gemäß dem Ohmschen Gesetz dem elektrischen Strom, der durch den Strommesswiderstand fließt. Darüber hinaus weist der bekannte Strommesswiderstand zwei bogenförmige Einschnitte in den Anschlussteilen auf, welche die Spannungsmesskontakte bogenförmig umgeben und auch als Stromschatten bezeichnet werden. Diese Stromschatten verbessern die Temperaturabhängigkeit der Messung. Der vorstehend beschriebene bekannte Strommesswiderstand ist jedoch hinsichtlich der Messgenauigkeit noch nicht optimal.

Ferner ist zum Stand der Technik hinzuweisen auf US 2016/077135 A1 und DE 10 2013 005 939 A1.

Der Erfindung liegt deshalb die Aufgabe zugrunde, einen entsprechend verbesserten Strommesswiderstand zu schaffen.

Diese Aufgabe wird durch einen erfindungsgemäßen Strommesswiderstand gemäß dem Hauptanspruch gelöst.

Die Erfindung umfasst die allgemeine technische Lehre, nicht nur ein Paar von Spannungsmesskontakten vorzusehen, sondern mehrere Paare von Spannungsmesskontakten, die in Stromflussrichtung hintereinander angeordnet sind und mehrere Messkanäle bilden können. Dadurch lässt sich die Messgenauigkeit des Strommesswiderstands deutlich verbessern. So ermöglichen die mehrfachen Paare von Spannungsmesskontakten bereits physikalisch eine mehrfache Redundanz bei der Spannungsmessung und eine Verifikation der Strommessung.

Der erfindungsgemäße Strommesswiderstand weist zunächst in Übereinstimmung mit dem eingangs beschriebenen bekannten Strommesswiderstand ein erstes Anschlussteil auf, das aus einem Leitermaterial (z.B. Kupfer, Kupferlegierung) besteht und zur Einleitung des zu messenden elektrischen Stroms in den Strommesswiderstand dient.

Weiterhin umfasst der erfindungsgemäße Strommesswiderstand in Übereinstimmung mit dem eingangs beschriebenen bekannten Strommesswiderstand ein zweites Anschlussteil, das ebenfalls aus einem Leitermaterial (z.B. Kupfer, Kupferlegierung) besteht und dazu dient, den zu messenden elektrischen Strom wieder aus dem Strommesswiderstand abzuführen.

Darüber hinaus weist auch der erfindungsgemäße Strommesswiderstand in Übereinstimmung mit dem eingangs beschriebenen bekannten Strommesswiderstand ein Widerstandselement auf, dass aus einem Widerstandsmaterial (z.B. Manganin®) besteht, wobei das Widerstandselement in Stromflussrichtung zwischen den beiden Anschlussteilen angeordnet ist, so dass der zu messende elektrische Strom durch das Widerstandselement fließt.

Weiterhin hat auch der erfindungsgemäße Strommesswiderstand in Übereinstimmung mit dem eingangs beschriebenen bekannten Strommesswiderstand mindestens einen Einschnitt in mindestens einem der Anschlussteile, wobei der Einschnitt einen der Spannungsmesskontakte umgibt und einen Stromfluss quer über den Einschnitt verhindert. Derartige Einschnitte werden auch als Stromschatten bezeichnet und verformen die Äquipotentiallinien und das Stromflussfeld innerhalb des Strommesswiderstands, was zur Verbesserung der Messgenauigkeit beiträgt.

Im Gegensatz zu dem eingangs beschriebenen bekannten Strommesswiderstand weist der Strommesswiderstand gemäß der Erfindung jedoch mehrere Paare von Spannungsmesskontakten auf, die in Stromflussrichtung hintereinander angeordnet sind und eine Spannungsmessung an verschiedenen Messpunkten des Strommesswiderstands ermöglichen. Dadurch lassen sich mehrere verschiedene Messkanäle bilden, indem die Spannungsmesskontakte in unterschiedlichen Paarungen zur Spannungsmessung verwendet werden.

Gemäß der Erfindung ist der Einschnitt und der von dem Einschnitt umgebene Spannungsmesskontakt in dem Anschlussteil bezüglich der Position quer zu der Stromflussrichtung mittig angeordnet. Dadurch unterscheidet sich der erfindungsgemäße Strommesswiderstand auch von dem eingangs beschriebenen bekannten Strommesswiderstand, bei dem die Einschnitte von der Seitenkante der Anschlussteile ausgehen und somit randnah angeordnet sind, d.h. nicht mittig.

Hierbei ist zu erwähnen, dass der Strommesswiderstand eine bestimmte Mittelachse parallel zu der Stromflussrichtung aufweist, während die Anschlussteile mit dem Einschnitt eine bestimmte Breite quer zu der Stromflussrichtung haben. Der von dem Einschnitt umgebene Spannungsmesskontakt weist vorzugsweise gegenüber der Mittelachse des Strommesswiderstands eine Exzentrizität auf, die kleiner ist als 50%, 40%, 30%, 20%, 10% oder sogar 5% der Breite des Strommesswiderstands. Die Exzentrizität in diesem Sinne ist hierbei der laterale Abstand zwischen dem Mittelpunkt des von dem Einschnitt umgebenen Spannungsmesskontakt einerseits und der Mittelachse des Strommesswiderstands andererseits.

Bei dem bevorzugten Ausführungsbeispiel der Erfindung weist der Einschnitt in dem Anschlussteil eine bestimmte Breite quer zu der Stromflussrichtung auf, die vorzugsweise höchstens 60%, 50% oder sogar höchstens 40% der Breite des Anschlussteils beträgt.

Bei dem eingangs beschriebenen bekannten Strommesswiderstand ist der Einschnitt (Stromschatten) in den Anschlussteilen jeweils bogenförmig, was auch bei dem erfindungsgemäßen Strommesswiderstand der Fall sein kann. Vorzugsweise ist der Einschnitt jedoch U-förmig mit einer Basis quer zu der Stromflussrichtung und Schenkeln, die parallel zu der Stromflussrichtung verlaufen und dem Widerstandselement zugewandt sind. Die Basis des U-förmigen Einschnitts befindet sich also in dem Anschlussteil, während die Schenkel dem Widerstandselement zugewandt sind. Alternativ besteht jedoch auch die Möglichkeit, dass der Einschnitt V-förmig ausgebildet ist.

Weiterhin ist zu erwähnen, dass die Schenkel des U-förmigen oder V-förmigen Einschnitts rechtwinklig zu der Stromflussrichtung vorzugsweise eine bestimmte Breite aufweist, die mindestens so groß ist wie die Dicke des Widerstandselements und/oder die Dicke der Anschlussteile und/oder die Dicke des gesamten Strommesswiderstands.

Darüber hinaus ist zu erwähnen, dass die Basis des U-förmigen Einschnitts parallel zu der Stromflussrichtung eine bestimmte Breite aufweist, die vorzugsweise ebenfalls mindestens so groß ist wie die Dicke des Widerstandselements und/oder die Dicke der Anschlussteile und/oder die Dicke des gesamten Strommesswiderstands.

Der Einschnitt ist also in der Basis und in den Schenkeln der U-Form mindestens so breit wie die Dicke des Widerstandselements und/oder die Dicke der Anschlussteile und/oder die Dicke des gesamten Strommesswiderstands.

Bei dem bevorzugten Ausführungsbeispiel der Erfindung ragen die Schenkel des U-förmigen oder V-förmigen Einschnitts in der Stromflussrichtung bis in das Widerstandselement hinein und enden in dem Widerstandselement. Ein Teil der Schenkel des Einschnitts liegt also in dem Widerstandselement, während ein anderer Teil der Schenkel des Einschnitts in den Anschlussteilen liegt. Die Schenkellänge innerhalb des Widerstandselements kann beispielsweise 6 mm betragen, mit einer Abweichung von maximal $\pm 3$mm, $\pm 2$mm, $\pm 1$mm, $\pm 0,5$mm oder sogar $\pm 0,2$mm. Weiterhin ist zu erwähnen, dass die Schenkellänge der Schenkel des Einschnitts innerhalb des Widerstandselements vorzugsweise im Bereich von 10%-90%, 20%-80% oder 30%-70% der Länge des Widerstandselements in der Stromflussrichtung beträgt.

Alternativ besteht jedoch im Rahmen der Erfindung auch die Möglichkeit, dass die Schenkel des Einschnitts in der Stromflussrichtung vor dem Widerstandselement in dem Anschlussteil enden. Hierbei befindet sich der Einschnitt also vollständig innerhalb des jeweiligen Anschlussteils und ragt nicht bis in das Widerstandselement hinein. Hierbei kann die Schenkellänge des Einschnitts beispielsweise 4 mm betragen mit einer maximalen Abweichung von $\pm 2$mm, $\pm 1$mm, $\pm 0,5$mm oder sogar $\pm 0,2$mm. Weiterhin ist hierbei zu erwähnen, dass die Schenkellänge im Bereich von 10%-90%, 20%-80% oder 30%-70% der Breite des Strommesswiderstands liegen kann.

In einer anderen Alternative enden die Schenkel des Einschnitts dagegen in Stromflussrichtung genau an der Grenze zwischen dem Widerstandselement und dem Anschlussteil.

Es wurde bereits vorstehend kurz erwähnt, dass der Einschnitt in dem Anschlussteil einen Spannungsmesskontakt umgibt und als Stromschatten wirkt. Der Einschnitt begrenzt also in dem übrigen Anschlussteil eine Kontaktinsel, wobei die Kontaktinsel zwischen dem Einschnitt und dem Widerstandselement vorzugsweise eine Fläche von mindestens 4 mm$^2$, 5 mm$^2$, 6 mm$^2$, 8 mm$^2$ oder 10 mm$^2$ aufweist. Die Kontaktinsel wird also einerseits von dem Einschnitt und andererseits von dem Widerstandselement begrenzt.

Weiterhin ist zu erwähnen, dass vorzugsweise in den beiden Anschlussteilen jeweils mindestens ein Einschnitt angeordnet ist, der eine Kontaktinsel für einen Spannungsmesskontakt umgibt. Die Einschnitte liegen hierbei vorzugsweise paarweise auf gegenüberliegenden Seiten des Widerstandselements und zwar vorzugsweise in der gleichen lateralen Position bezüglich der Mittelachse des Strommesswiderstands. Es ist jedoch alternativ auch möglich, dass die Einschnitte auf den beiden gegenüberliegenden Seiten des Widerstandselements in lateraler Richtung versetzt angeordnet sind.

Ferner besteht im Rahmen der Erfindung auch die Möglichkeit, dass in zumindest einem der beiden Anschlussteile bezüglich der Stromflussrichtung nebeneinander mehrere Einschnitte angeordnet sind, die jeweils eine Kontaktinsel für einen Spannungsmesskontakt umgeben. Beispielsweise können in den beiden Anschlussteilen jeweils zwei Einschnitte angeordnet sein, die bezüglich der Mittelachse des Strommesswiderstands und bezüglich des Widerstandselements symmetrisch angeordnet sind.

In einer Variante der Erfindung ist das Widerstandselement in lateraler Richtung in ein erstes Teil und ein zweites Teil aufgeteilt, so dass der zu messende Strom in einen ersten Strompfad durch das erste Teil und einen zweiten Strompfad durch das zweite Teil des Widerstandselements aufgeteilt wird. Diese Aufteilung wird durch eine Aussparung erreicht, die einen Stromfluss quer über die Aussparung verhindert, so dass die beiden Strompfade beiderseits der Aussparung verlaufen. Diese Aussparung kann beispielsweise aus einer Ausstanzung bestehen. Hierbei ist zu erwähnen, dass sich die Aussparung in Stromflussrichtung vorzugsweise über die gesamte Länge des Widerstandselements erstreckt und auch bis in die Anschlussteile reichen kann.

Bei dieser Erfindungsvariante können in den beiden Strompfaden jeweils mehrere Spannungsmesskontakte hintereinander angeordnet sein und zwar vorzugsweise entlang der Stromflussrichtung hintereinander.

Weiterhin ist vorzugsweise vorgesehen, dass zumindest ein Paar von Spannungsmesskontakten an den beiden Teilen des Widerstandselements angreift. Beispielsweise können diese Spannungsmesskontakte direkt auf dem Widerstandselement angeordnet sein. In dem bevorzugten Ausführungsbeispiel sind diese Spannungsmesskontakte jedoch unmittelbar an der Grenze zu dem Widerstandselement auf dem jeweiligen Anschlussteil angeordnet, um den Spannungsabfall zwischen den beiden Teilen des Widerstandselements quer zur Stromflussrichtung zu messen.

Bei dieser Erfindungsvariante mit mehreren parallelen Strompfaden können in den beiden Strompfaden auch jeweils mehrere Spannungsmesskontakte bezüglich der Stromflussrichtung nebeneinander angeordnet sein. Beispielsweise können die Spannungsmesskontakte in den beiden Strompfaden jeweils matrixförmig in Reihen quer zur Stromflussrichtung und Spuren längs der Stromflussrichtung angeordnet sein.

Es wurde bereits vorstehend kurz erwähnt, dass es sich bei dem Leitermaterial beispielsweise um Kupfer oder eine Kupferlegierung handeln kann. Alternativ besteht jedoch auch die Möglichkeit, dass es sich bei dem Leitermaterial der Anschlussteile um Aluminium oder eine Aluminiumlegierung handelt. Die Erfindung ist jedoch hinsichtlich der verwendeten Leitermaterialien nicht auf diese Materialien beschränkt, sondern auch mit anderen Materialien realisierbar, die elektrisch leitfähig sind. Es ist jedoch zu erwähnen, dass das Leitermaterial der Anschlussteile einen kleineren spezifischen elektrischen Widerstand aufweisen sollte als das Widerstandsmaterial des Widerstandselements.

Hinsichtlich des Widerstandsmaterials des Widerstandselements bestehen im Rahmen der Erfindung vielfältige Möglichkeiten. Beispielsweise kann es sich bei dem Widerstandsmaterial um eine Kupfer-Legierung handeln, insbesondere eine Kupfer-Mangan-Zinn-Legierung oder eine Kupfer-Mangan-Nickel-Legierung oder eine Kupfer-Chrom-Legierung. Ein weiteres Beispiel für ein grundsätzlich geeignetes Widerstandsmaterial ist eine Nickellegierung, wie beispielsweise Nickel-Chrom oder Kupfer-Nickel.

Es wurde bereits vorstehend kurz erwähnt, dass das Widerstandselement zwischen den beiden Anschlussteilen angeordnet ist und mit den beiden Anschlussteilen verbunden ist. Beispielsweise kann diese Verbindung in einer Schweißverbindung (z.B. Elektronenstrahlverschweißung) bestehen, wie sie beispielsweise aus EP 0 605 800 A1 bekannt ist

Das Widerstandsmaterial hat vorzugsweise einen spezifischen elektrischen Widerstand, der kleiner ist als $2 \cdot 10^{-4}\ \Omega\cdot m$, $2.10^{-5}\ \Omega\cdot m$ oder $2.10^{-6}\ \Omega\cdot m$.

Das Widerstandsmaterial weist vorzugsweise einen spezifischen elektrischen Widerstand auf, der größer ist als $2\cdot10^{-6}\ \Omega\cdot m$, $2\cdot10^{-7}\ \Omega\cdot m$, während der spezifische elektrische Widerstand des Widerstandsmaterials vorzugsweise kleiner ist als $10^{-6}\ \Omega\cdot m$ oder $10^{-7}\ \Omega\cdot m$.

Allgemein ist zu erwähnen, dass der Strommesswiderstand vorzugsweise niederohmig ist mit einem Widerstandswert von höchstens als $1\ \mu\Omega$, $10\ \mu\Omega$, $50\ \mu\Omega$, $100\ \mu\Omega$, $500\ \mu\Omega$, $10\ m\Omega$, $5\ m\Omega$, $2\ m\Omega$ oder $1\ m\Omega$.

Ferner ist zu erwähnen, dass der Strommesswiderstand eine Strombelastbarkeit von mindestens 1A, 10A, 100A, 1kA oder 5 kA aufweisen kann, bezogen auf Dauerstrombelastung oder Pulsbelastung.

Hinsichtlich der Gestaltung des Strommesswiderstands ist zu erwähnen, dass das Widerstandselement und/oder die Anschlussteile plattenförmig sein können, insbesondere als ebene Platten.

Bezüglich der Abmessungen ist zu bemerken, dass der Strommesswiderstand in der Stromflussrichtung eine Länge aufweisen kann, die kleiner ist als 30cm, 20cm oder 10cm, während die Breite vorzugsweise kleiner ist als 20cm, 10cm oder 5cm. Die Dicke des Strommesswiderstands ist dagegen vorzugsweise kleiner ist als 10mm, 5mm oder 4mm.

Ferner ist zu erwähnen, dass die beiden Anschlussteile jeweils mindestens einen Stromanschluss aufweisen können, um den Strom einzuleiten bzw. auszuleiten, wobei die einzelnen Stromanschlüsse vorzugsweise jeweils mindestens eine Bohrung in dem jeweiligen Anschlussteil aufweisen, insbesondere jeweils zwei Bohrungen, die bezüglich der Stromflussrichtung nebeneinander angeordnet sind. Alternativ können die Stromanschlüsse auch aus Anschlussschrauben bestehen, die rechtwinklig von den plattenförmigen Anschlussteilen abstehen, wie es aus EP 0 605 800 A1 bekannt ist.

Die vorstehend erwähnten Spannungsmesskontakte umfassen vorzugsweise jeweils Kontaktinseln, die aus einer elektrisch leitfähigen Beschichtung auf dem jeweiligen Anschlussteil bestehen. Beispielsweise können die einzelnen Kontaktinseln jeweils im Wesentlichen rechteckig sein und eine Beschichtung aus einem anderen Leitermaterial umfassen als die Anschlussteile.

Die Kontaktinseln können auf dem Strommesswiderstand matrixförmig in mehreren, insbesondere vier, Reihen rechtwinklig zu der Stromflussrichtung und mehreren, insbesondere drei, Spuren parallel zu der Stromflussrichtung angeordnet sein.

Weiterhin ist zu erwähnen, dass die Erfindung nicht nur Schutz beansprucht für den vorstehend beschriebenen erfindungsgemäßen Strommesswiderstand als einzelnes Bauteil. Vielmehr beansprucht die Erfindung auch Schutz für eine komplette Strommesseinrichtung mit einem solchen Strommesswiderstand und einer Spannungsmesseinrichtung, die zur Spannungsmessung an den Spannungsmesskontakten des Strommesswiderstands dient und entsprechende Spannungsmesswerte liefert, wobei die Spannungsmesseinrichtung mehrere Messkanäle bilden kann. Darüber hinaus umfasst die erfindungsgemäße Strommesseinrichtung vorzugsweise auch eine Auswertungseinheit zur Berechnung des durch den Strommesswiderstand fließenden elektrischen Stroms in Abhängigkeit von den Spannungsmesswerten. Hierbei ist es möglich, dass die Auswertungseinheit die verschiedenen Spannungsmesswerte mit Gewichtungsfaktoren gewichtet. Weiterhin ist es im Rahmen der Erfindung möglich, dass die Auswertungseinheit eine automatische Kalibrierung ausführt, was aufgrund der mehrfachen Redundanz möglich ist. Allgemein ist noch zu erwähnen, dass die verschiedenen Spannungsmesskontakte eine Wheatstonesche Messbrücke bilden können.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert.

Figur 1 zeigt eine Perspektivansicht eines erfindungsgemäßen Strommesswiderstands.

Figur 1B zeigt eine Aufsicht auf den Strommesswiderstand gemäß Figur 1A.

Figur 1C zeigt eine Ausschnittsvergrößerung aus Figur 1B mit einem Spannungsdiagramm.

Figur 2 zeigt eine Abwandlung von Figur 1B mit zwei Einschnitten in den beiden Anschlussteilen.

Figur 3 zeigt eine nicht erfindungsgemäße Abwandlung des Ausführungsbeispiels gemäß den Figuren 1A-1C mit einer Aussparung in dem Strommesswiderstand zur Aufteilung des Stromflusses in zwei parallele Strompfade.

Figur 4 zeigt eine nicht erfindungsgemäße Abwandlung von Figur 3.

Figur 5 zeigt eine nicht erfindungsgemäße Abwandlung von Figur 3.

Figur 6 zeigt eine nicht erfindungsgemäße weitere Abwandlung von Figur 3.

Figur 7 zeigt schließlich eine Strommesseinrichtung mit einem erfindungsgemäßen Strommesswiderstand.

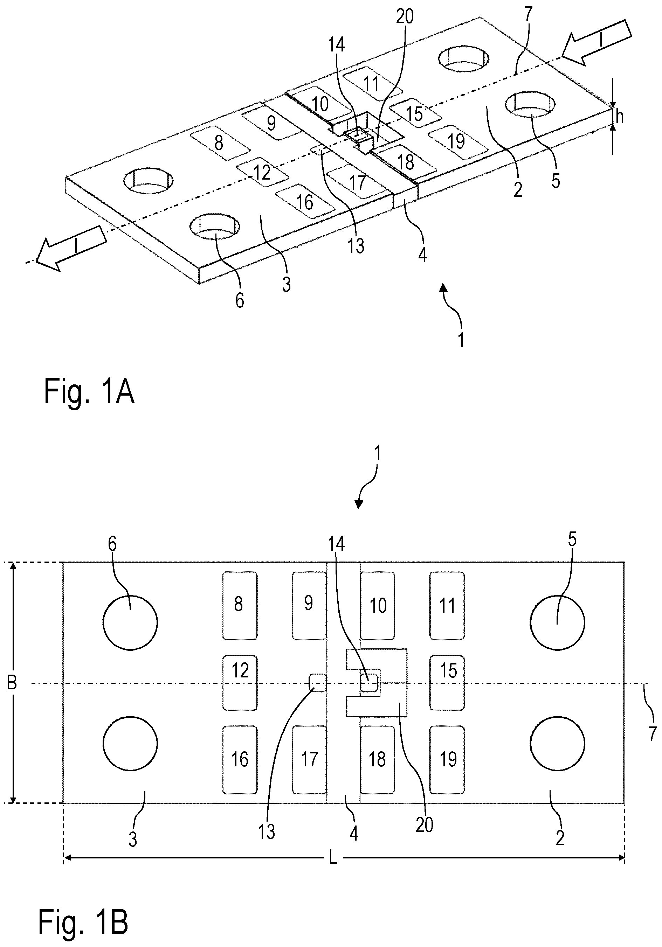

Im Folgenden wird nun ein erstes Ausführungsbeispiel eines erfindungsgemäßen Strommesswiderstands 1 beschrieben, wie er in den Figuren 1A-1C dargestellt ist. Der Strommesswiderstand 1 besteht im Wesentlichen aus zwei Anschlussteilen 2, 3 aus einem Leitermaterial (z.B. Kupfer) und einem Widerstandselement 4 aus einem Widerstandsmaterial (z.B. Manganin®), wobei das Widerstandselement 4 in Stromflussrichtung zwischen den beiden Anschlussteilen 2, 3 angeordnet ist, so dass ein zu messender elektrischer Strom I über das Anschlussteil 2 in den Strommesswiderstand 1 eingeleitet wird, anschließend durch das Widerstandselement 4 fließt und dann von dem Anschlussteil 3 wieder aus dem Strommesswiderstand 1 ausgeleitet wird. Die über dem Widerstandselement 4 abfallende elektrische Spannung ist also entsprechend dem Ohmschen Gesetz ein Maß für den elektrischen Strom I, der durch den Strommesswiderstand 1 fließt, was eine Strommessung gemäß der an sich bekannten Vierleitertechnik ermöglicht.

Zur Einleitung bzw. Ausleitung des elektrischen Stroms befinden sich in den beiden Anschlussteilen 2, 3 jeweils Stromanschlüsse 5 bzw. 6 in Form von zwei Bohrungen, die beiderseits einer Mittelachse 7 des Strommesswiderstands 1 angeordnet sind. Die Bohrungen der Stromanschlüsse 5 bzw. 6 ermöglichen das Anschrauben von entsprechenden Kontakten, wie es an sich aus dem Stand der Technik bekannt ist.

Die Spannungsmessung an dem Strommesswiderstand 1 erfolgt durch zahlreiche Spannungsmesskontakte 8-19, die auf den beiden Anschlussteilen 2, 3 matrixförmig in Reihen quer zu der Stromflussrichtung und Spuren entlang der Stromflussrichtung angeordnet sind. Die Spannungsmesskontakte 8-19 sind jeweils als rechteckige Kontaktinseln ausgebildet, die aus einer separaten leitfähigen Beschichtung bestehen, die auf die jeweiligen Anschlussteil 2 bzw. 3 aufgebracht ist. Die Spannungsmesskontakte 8-19 können im Rahmen der Spannungsmessung in beliebigen Paarungen zusammengeschaltet werden und so mehrere Spannungsmesskanäle bilden.

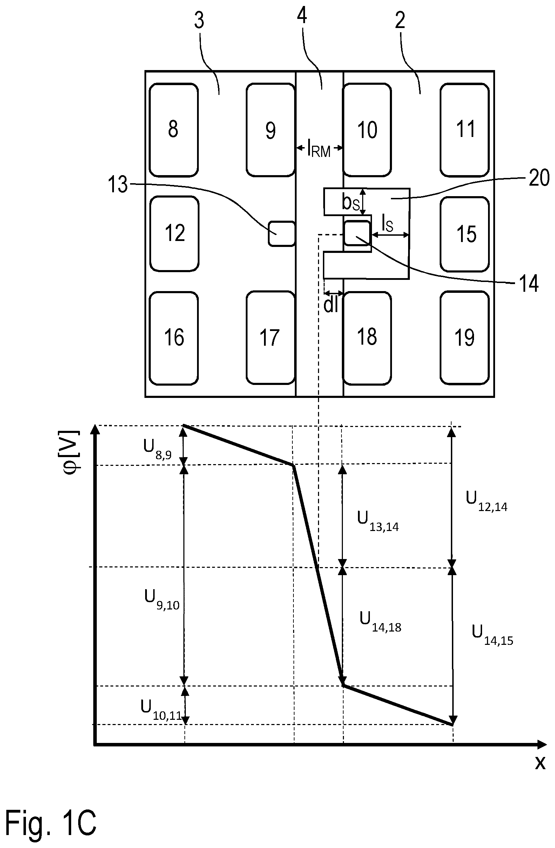

Der Spannungsmesskontakt 14 ist hierbei von einem Einschnitt 20 umgeben, der U-förmig ausgebildet ist. Der U-förmige Einschnitt 20 weist zunächst eine Basis innerhalb des Anschlussteils 2 auf. Weiterhin hat der U-förmige Einschnitt 20 zwei Schenkel, die in Stromflussrichtung verlaufen und bis in das Widerstandselement 4 hineinreichen, wie insbesondere aus Figur 1C ersichtlich ist. Die Schenkel des U-förmigen Einschnitts 20 haben hierbei eine Breite $b_S$ rechtwinklig zu der Stromflussrichtung, während die Basis des U-förmigen Einschnitts 20 eine Breite $I_S$ entlang der Stromflussrichtung hat. Weiterhin ist aus Fig. 1C ersichtlich, dass das Widerstandselement 4 eine Breite $I_{RM}$ entlang der Stromflussrichtung hat. Schließlich ist aus Figur 1C auch noch ersichtlich, dass die Schenkel des U-förmigen Einschnitts 20 innerhalb des Widerstandselements 4 eine Schenkellänge dl haben.

Für die vorstehend genannten Größen sollten folgende Dimensionierungsregeln eingehalten werden:

$$dl = 0{,}1\text{-}0{,}9 \cdot l_{RM}$$

$$l_S \geq h$$

$$b_S \geq h$$

Der Strommesswiderstand 1 weist hierbei entlang der Stromflussrichtung eine Länge L=80mm und quer zu der Stromflussrichtung eine Breite B=40mm auf, während die Dicke h=3mm beträgt.

Das Potentialdiagramm gemäß Figur 1C zeigt qualitativ den Zusammenhang der Spannungsmesswerte für verschiedene Paare der Spannungsmesskontakte 8-19. Die Indizes der Spannungswerte in dem Potentialdiagramm entsprechend dabei den Bezugszeichen der zugehörigen Spannungsmesskontakte. Der Spannungswert $U_{1,2}$ bezeichnet also die Spannung zwischen den Spannungsmesskontakten 1 und 2.

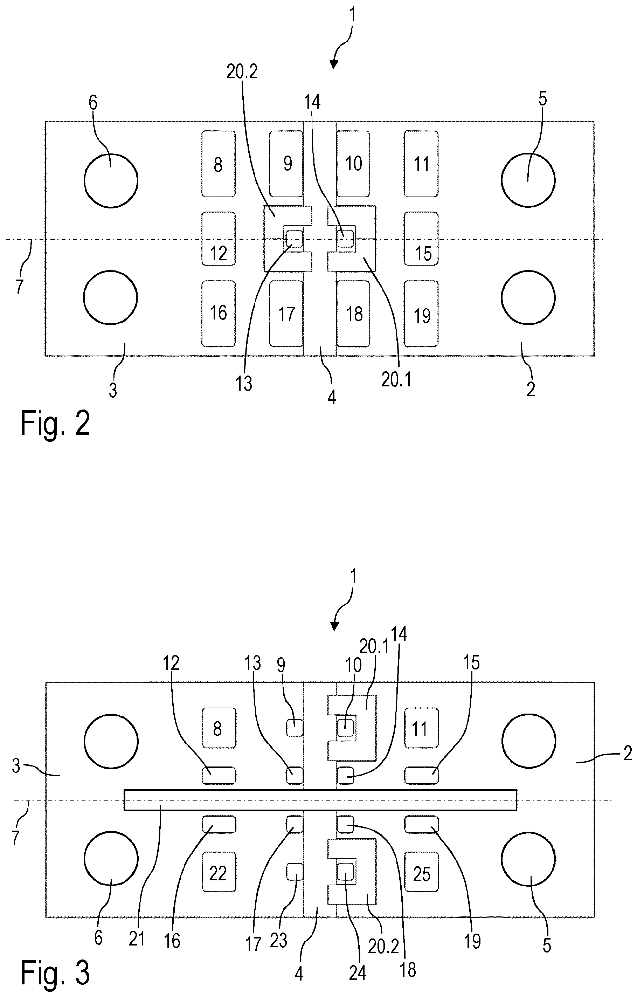

Figur 2 zeigt eine Abwandlung des Ausführungsbeispiels gemäß den Figuren 1A-1C, so dass zur Vermeidung von Wiederholungen zunächst auf die vorstehende Beschreibung verwiesen wird, wobei für entsprechende Einzelheiten dieselben Bezugszeichen verwendet werden.

Eine Besonderheit dieses Ausführungsbeispiels besteht darin, dass der Strommesswiderstand 1 zwei Einschnitte 20.1, 20.2 aufweist, die in den beiden Anschlussteilen 2 bzw. 3 auf gegenüberliegenden Seiten des Widerstandselements 4 angeordnet sind.

Figur 3 zeigt eine nicht erfindungsgemäße Abwandlung der vorstehend beschriebenen Ausführungsbeispiele, so dass zur Vermeidung wieder von Wiederholungen wieder auf die vorstehende Beschreibung verwiesen wird, wobei für entsprechende Einzelheiten dieselben Bezugszeichen verwendet werden.

Eine Besonderheit dieses Ausführungsbeispiels besteht zunächst darin, dass die beiden Einschnitte 20.1, 20.2 nicht auf gegenüberliegenden Seiten des Widerstandselements 4 angeordnet sind, sondern auf derselben Seite des Widerstandselements 4, nämlich in dem Anschlussteil 2.

Eine weitere Besonderheit dieses Ausführungsbeispiels besteht darin, dass der Strommesswiderstand 1 eine Aussparung 21 aufweist, die sich entlang der Mittelachse 7 des Strommesswiderstands 1 über die gesamte Länge des Widerstandselements 4 erstreckt und bis in die angrenzenden Anschlussteil 2 bzw. 3 reicht. Die Aussparung 21 kann beispielsweise aus einer Ausstanzung bestehen und verhindert einen Stromfluss quer über die Aussparung 21. Die Aussparung 21 teilt den Strom I also in zwei Strompfade beiderseits der Aussparung 21 auf.

Weiterhin ist zu erwähnen, dass in diesem Ausführungsbeispiel vier weitere Spannungsmesskontakte 22-25 vorgesehen sind. Die Spannungsmesskontakte 8-25 sind hierbei also in vier Reihen und vier Spuren matrixförmig angeordnet.

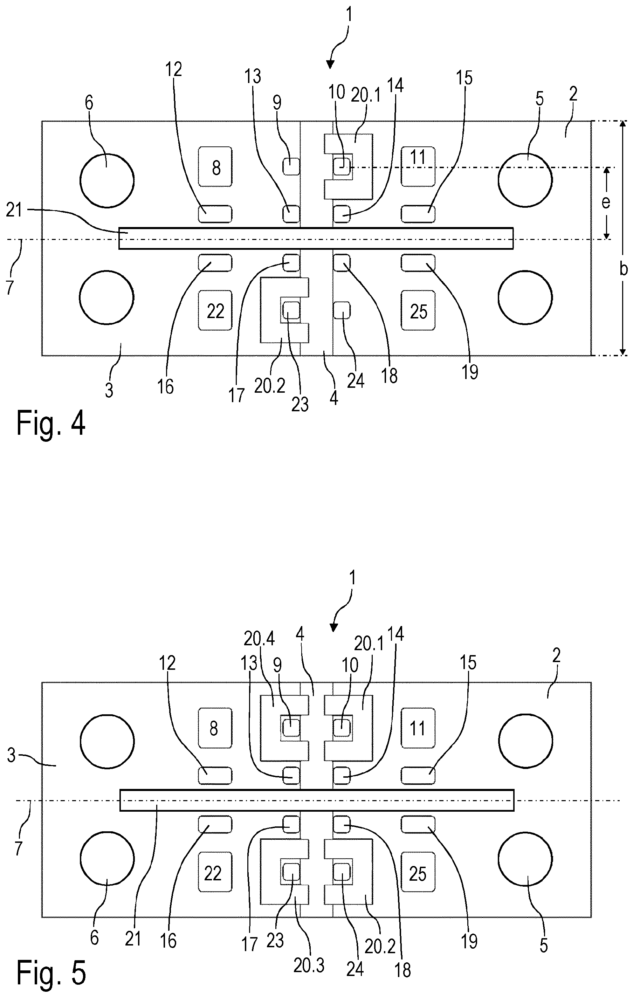

Figur 4 zeigt eine nicht erfindungsgemäße Abwandlung des Ausführungsbeispiels gemäß Figur 3, so dass zur Vermeidung von Wiederholungen auf die vorstehende Beschreibung verwiesen wird, wobei für entsprechende Einzelheiten dieselben Bezugszeichen verwendet werden.

Hierbei ist zu erwähnen, dass der Einschnitt 20.1 bezüglich der Mittelachse 7 des Strommesswiderstands exzentrisch angeordnet ist mit einer bestimmten Exzentrizität e bezüglich der Mittelachse 7.

Figur 5 zeigt wieder eine weitere nicht erfindungsgemäße Abwandlung des Ausführungsbeispiels gemäß Figur 3, so dass zur Vermeidung von Wiederholungen wieder auf die vorstehende Beschreibung verwiesen wird, wobei für entsprechende Einzelheiten dieselben Bezugszeichen verwendet werden.

Eine Besonderheit dieses Ausführungsbeispiels besteht darin, dass insgesamt vier Einschnitte 20.1-20.4 in dem Strommesswiderstand 1 angeordnet sind.

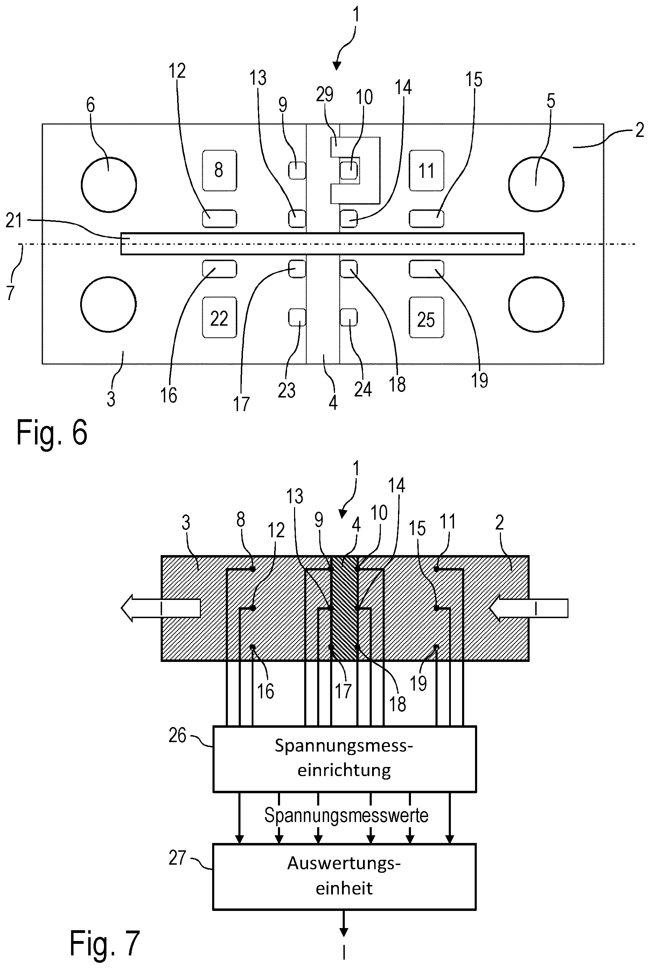

Figur 6 zeigt eine nicht erfindungsgemäße Abwandlung des Ausführungsbeispiels gemäß Figur 3, so dass zur Vermeidung von Wiederholungen auf die vorstehende Beschreibung verwiesen wird, wobei für entsprechende Einzelheiten dieselben Bezugszeichen verwendet werden.

Eine Besonderheit dieses Ausführungsbeispiels besteht darin, dass nur ein einziger Einschnitt 20 vorhanden ist.

Figur 7 zeigt eine komplette Strommesseinrichtung mit dem erfindungsgemäßen Strommesswiderstand 1 und einer Spannungsmesseinrichtung 26, die an den Spannungsmesskontakten 8-19 jeweils paarweise die Spannung misst und somit mehrere Messkanäle bereitstellt.

Die gemessenen Spannungsmesswerte werden dann an eine Auswertungseinheit 27 weitergeleitet, die den elektrischen Strom I aus den Spannungsmesswerten berechnet, wobei die Auswertungseinheit 27 die einzelnen Spannungsmesswerte auch einzeln gewichten kann, wobei auch eine automatische Kalibrierung möglich ist.

Bezugszeichenliste:

| | |
|---|---|
| 1 | Strommesswiderstand |
| 2, 3 | Anschlussteile |
| 4 | Widerstandselement |
| 5, 6 | Stromanschlüsse (Bohrungen in den Anschlussteilen) |
| 7 | Mittelachse des Strommesswiderstands |
| 8-19 | Spannungsmesskontakte |
| 20, 20.1-20.4 | Einschnitt |
| 21 | Aussparung in dem Strommesswiderstand Spannungsmesseinrichtung |
| 22-25 | Spannungsmesskontakte |

| 26 | Spannungsmesseinrichtung |
| 27 | Auswertungseinheit |
| B | Breite des Strommesswiderstands rechtwinklig zur Stromflussrichtung |
| $b_S$ | Breite der Schenkel des Einschnitts rechtwinklig zur Stromflussrichtung |
| dl | Schenkellänge der Schenkel des Einschnitts innerhalb des Widerstandselements |
| e | Exzentrizität des Einschnitts |
| h | Dicke des Strommesswiderstands |
| I | Strom |
| $I_{RM}$ | Breite des Widerstandselements entlang der Stromflussrichtung |
| $I_S$ | Breite der Basis des Einschnitts entlang der Stromflussrichtung |
| L | Länge des Strommesswiderstands entlang der Stromflussrichtung |

**Patentansprüche**

1. Strommesswiderstand (1) zur Messung eines elektrischen Stroms (I), mit

a) einem ersten Anschlussteil (2) aus einem Leitermaterial zur Einleitung des zu messenden elektrischen Stroms (I) in den Strommesswiderstand (1),
b) einem zweiten Anschlussteil (3) aus einem Leitermaterial zum Abführen des zu messenden elektrischen Stroms (I) aus dem Strommesswiderstand (1),
c) einem Widerstandselement (4) aus einem Widerstandsmaterial, wobei das Widerstandselement (4) in Stromflussrichtung zwischen dem ersten Anschlussteil (2) und dem zweiten Anschlussteil (3) angeordnet ist, so dass der zu messende Strom (I) durch das Widerstandselement (4) fließt, und
d) mindestens einem Paar von Spannungsmesskontakten (8-19; 22-25) zur Messung eines Spannungsabfalls über dem Widerstandselement (4), wobei die Spannungsmesskontakte (8-19; 22-25) jeweils an einem der Anschlussteile (2, 3) angreifen, und
e) mindestens einem Einschnitt (20; 20.1-20.4) in mindestens einem der Anschlussteile (2, 3), wobei der Einschnitt (20; 20.1-20.4) einen der Spannungsmesskontakte (8-19; 22-25) umgibt und einen Stromfluss quer über den Einschnitt (20; 20.1-20.4) verhindert,
**dadurch gekennzeichnet,**
f) **dass** mehrere Paare von Spannungsmesskontakten (8-19; 22-25) in Stromflussrichtung hintereinander angeordnet sind, und
g) **dass** der Einschnitt (20; 20.1-20.4) und der von dem Einschnitt (20; 20.1-20.4) umgebene Spannungsmesskontakt (14) in dem Anschlussteil (2) bezüglich der Position quer zu der Stromflussrichtung mittig angeordnet ist.

2. Strommesswiderstand (1) nach Anspruch 1, **dadurch gekennzeichnet,**

a) **dass** der Strommesswiderstand (1) eine bestimmte Mittelachse (7) parallel zur Stromflussrichtung aufweist,
b) **dass** das Anschlussteil (2) mit dem Einschnitt (20.1) eine bestimmte Breite (B) quer zu der Stromflussrichtung aufweist, und
c) **dass** der von dem Einschnitt (20.1) umgebene Spannungsmesskontakt (10) gegenüber der Mittelachse (7) des Strommesswiderstands (1) eine Exzentrizität (e) aufweist, die kleiner ist als 50%, 40%, 30%, 20%, 10% oder 5% der Breite (B) des Strommesswiderstands (1).

3. Strommesswiderstand (1) nach einem der vorhergehenden Ansprüche, **dadurch gekennzeichnet,**

a) **dass** das Anschlussteil mit dem Einschnitt (20; 20.1-20.4) eine bestimmte Breite (B) quer zu der Stromflussrichtung aufweist, und
b) **dass** sich der Einschnitt (20; 20.1-20.4) in dem Anschlussteil quer zu der Stromflussrichtung über höchstens 60%, 50% oder 40% der Breite (B) des Anschlussteils (2, 3) erstreckt.

4. Strommesswiderstand (1) nach einem der vorhergehenden Ansprüche, **dadurch gekennzeichnet,**

a) **dass** der Einschnitt (20; 20.1-20.4) bogenförmig ist, insbesondere U-förmig oder V-förmig, mit einer Basis quer zu der Stromflussrichtung und Schenkeln, die parallel zu der Stromflussrichtung dem Widerstandselement (4) zugewandt sind, und/oder
b) **dass** die Schenkel des Einschnitts (20; 20.1-20.4) eine Breite ($b_s$) rechtwinklig zu der Stromflussrichtung aufweisen, die mindestens so groß ist wie die Dicke (h) des Widerstandselements (4), und/oder
c) **dass** die Basis des Einschnitts (20; 20.1-20.4) eine Breite ($I_s$) parallel zu der Stromflussrichtung aufweist, die mindestens so groß ist wie die Dicke (h) des Widerstandselements (4).

5. Strommesswiderstand (1) nach Anspruch 4, **dadurch gekennzeichnet,**

a) **dass** die Schenkel des Einschnitts (20; 20.1-20.4) in der Stromflussrichtung bis in das Widerstandselement (4) hineinragen und in dem Widerstandselement (4) enden, insbesondere mit einer Schenkellänge (dl) innerhalb des Widerstandselements (4) von

a1) 6mm mit einer Abweichung von maximal $\pm$3mm, $\pm$2mm, $\pm$1mm, $\pm$0,5mm oder $\pm$0,2mm, und/oder
a2) 10%-90%, 20%-80% oder 30%-70% der Länge ($I_{RM}$) des Widerstandselements (4) in der Stromflussrichtung, und/oder

b) **dass** die Schenkel des Einschnitts (20; 20.1-20.4) in der Stromflussrichtung vor dem Widerstandselement (4) in dem Anschlussteil (2, 3) enden, insbesondere mit einer Schenkellänge von

b1) 4mm mit einer Abweichung von maximal $\pm$2mm, $\pm$1mm, $\pm$0,5mm oder $\pm$0,2mm, und/oder
b2) 10%-90%, 20%-80%, 30%-70% der Breite des Strommesswiderstands (1), oder

c) **dass** die Schenkel des Einschnitts (20; 20.1-20.4) in Stromflussrichtung an der Grenze zwischen dem Widerstandselement (4) und dem Anschlussteil (2, 3) enden.

6. Strommesswiderstand (1) nach einem der vorhergehenden Ansprüche, **dadurch gekennzeichnet, dass** der Einschnitt (20; 20.1-20.4) in dem Anschlussteil (2, 3) eine Kontaktinsel begrenzt, wobei die Kontaktinsel zwischen dem Einschnitt (20; 20.1-20.4) und dem Widerstandselement (4) eine Fläche von mindestens 4mm$^2$, 5mm$^2$, 6mm$^2$, 8mm$^2$ oder 10mm$^2$ aufweist.

7. Strommesswiderstand (1) nach einem der vorhergehenden Ansprüche, **dadurch gekennzeichnet,**

a) **dass** in den beiden Anschlussteilen (2, 3) jeweils mindestens ein Einschnitt (20.1-20.4) angeordnet ist, der eine Kontaktinsel für einen Spannungsmesskontakt (9, 10, 23, 24) umgibt, und
b) **dass** die Einschnitte (20.1-20.4) paarweise auf gegenüberliegenden Seiten des Widerstandselements (4) in den Anschlussteilen (2, 3) angeordnet und zwar in der gleichen lateralen Position bezüglich der Mittelachse (7) des Strommesswiderstands (1).

8. Strommesswiderstand (1) nach einem der vorhergehenden Ansprüche, **dadurch gekennzeichnet, dass** in zumindest einem der beiden Anschlussteile (2, 3) bezüglich der Stromflussrichtung nebeneinander mehrere Einschnitte (20.1-20.4) angeordnet sind, die jeweils eine Kontaktinsel für einen Spannungsmesskontakt (9, 10, 23, 24) umgeben.

9. Strommesswiderstand (1) nach einem der vorhergehenden Ansprüche, **dadurch gekennzeichnet,**

a) **dass** das Widerstandselement (4) in ein erstes Teil und ein zweites Teil aufgeteilt ist, so dass der zu messende Strom (I) in einen ersten Strompfad durch das erste Teil und einen zweiten Strompfad durch das zweite Teil des Widerstandselements (4) aufgeteilt wird,
b) **dass** in dem Widerstandselement (4) eine Aussparung (21) vorgesehen ist, die einen Stromfluss quer über die Aussparung (21) verhindert, so dass die beiden Strompfade beiderseits der Aussparung (21) verlaufen,
c) **dass** sich die Aussparung (21) in Stromflussrichtung vorzugsweise über die gesamte Länge des Widerstandselements (4) erstreckt,
d) **dass** sich die Aussparung (21) in Stromflussrichtung vorzugsweise bis in die Anschlussteile (2, 3) erstreckt.

10. Strommesswiderstand (1) nach Anspruch 9, **dadurch gekennzeichnet,**

a) **dass** in dem ersten Strompfad jeweils mehrere Spannungsmesskontakte (8-19; 22-25) angeordnet sind und zwar entlang der Stromflussrichtung hintereinander,
b) **dass** in dem zweiten Strompfad jeweils mehrere Spannungsmesskontakte (8-19; 22-25) angeordnet sind und zwar entlang der Stromflussrichtung hintereinander, und
c) **dass** ein Paar von Spannungsmesskontakten (8-19; 22-25) an den beiden Teilen des Widerstandselements (4) angreift, insbesondere in den Anschlussteilen unmittelbar an der Grenze zu dem Widerstandselement (4), um den Spannungsabfall zwischen den beiden Teilen des Widerstandselements (4) quer zur Stromflussrichtung zu messen.

11. Strommesswiderstand (1) nach Anspruch 9 oder 10, **dadurch gekennzeichnet,**

a) **dass** in dem ersten Strompfad jeweils mehrere Spannungsmesskontakte (8-19; 22-25) angeordnet sind und zwar quer zur Stromflussrichtung nebeneinander,
b) **dass** in dem zweiten Strompfad jeweils mehrere Spannungsmesskontakte (8-19; 22-25) angeordnet sind und zwar quer zur Stromflussrichtung nebeneinander, und
c) **dass** an den beiden Teilen des Widerstandselements (4) jeweils mehrere Spannungsmesskontakte (8-19; 22-25) angeordnet sind und zwar quer zur Stromflussrichtung nebeneinander, insbesondere in den Anschlussteilen (2, 3) unmittelbar an der Grenze zu dem Widerstandselement (4),

12. Strommesswiderstand (1) nach einem der vorhergehenden Ansprüche,
**dadurch gekennzeichnet,**

a) **dass** das Leitermaterial Kupfer, eine Kupferlegierung, Aluminium oder eine Aluminiumlegierung ist, und/oder
b) **dass** das Leitermaterial der Anschlussteile (2, 3) einen kleineren spezifischen elektrischen Widerstand aufweist als das Widerstandsmaterial des Widerstandselements (4), und/oder
c) **dass** das Widerstandsmaterial des Widerstandselements (4) eine der folgende Legierungen ist:

c1) eine Kupfer-Legierung, insbesondere eine Kupfer-Mangan-Zinn-Legierung, insbesondere CuMn12Ni2 oder CuMn7Sn2,3, oder eine Kupfer-Mangan-Nickel-Legierung, insbesondere Cu84Ni4Mn12 oder Cu65Mn25Ni10, oder eine Kupfer-Chrom-Legierung,
c2) eine Nickellegierung, insbesondere NiCr oder CuNi, und/oder

d) **dass** das Widerstandselement (4) elektrisch und mechanisch mit den beiden Anschlussteilen verbunden ist, insbesondere durch eine Schweißverbindung, insbesondere durch eine Elektronenstrahlverschweißung, und/oder
e) **dass** das Widerstandsmaterial einen spezifischen elektrischen Widerstand aufweist, der kleiner ist als $2 \cdot 10^{-4}$ $\Omega \cdot m$, $2 \cdot 10^{-5}$ $\Omega \cdot m$ oder $2.10^{-6}$ $\Omega \cdot m$, und/oder
f) **dass** das Widerstandsmaterial einen spezifischen elektrischen Widerstand aufweist, der größer ist als $2 \cdot 10^{-6}$ $\Omega \cdot m$, $2 \cdot 10^{-7}$ $\Omega \cdot m$, und/oder
g) **dass** das Leitermaterial einen spezifischen elektrischen Widerstand aufweist, der kleiner ist als $10^{-6}$ $\Omega \cdot m$ oder $10^{-7}$ $\Omega \cdot m$, und/oder
h) **dass** der Widerstand niederohmig ist mit einem Widerstandswert von höchstens als 1 $\mu\Omega$, 10 $\mu\Omega$, 50 $\mu\Omega$, 100 $\mu\Omega$, 500 $\mu\Omega$, 10 m$\Omega$, 5 m$\Omega$, 2 m$\Omega$ oder 1 m$\Omega$, und/oder
i) **dass** der Strommesswiderstand (1) eine Strombelastbarkeit von mindestens 1A, 10A, 100A, 1kA oder 5 kA aufweist, und/oder
j) **dass** das Widerstandselement (4) plattenförmig ist, insbesondere als ebene Platte, und/oder
k) **dass** die Anschlussteile (2, 3) jeweils plattenförmig sind, insbesondere als ebene Platte, und/oder
l) dass der Strommesswiderstand (1) in der Stromflussrichtung eine Länge (L) aufweist, die kleiner ist als 30cm, 20cm oder 10cm, und/oder
m) **dass** der Strommesswiderstand (1) rechtwinklig der Stromflussrichtung eine Breite (B) aufweist, die kleiner ist als 20cm, 10cm oder 5cm, und/oder
n) **dass** der Strommesswiderstand (1) eine Dicke (h) aufweist, die kleiner ist als 10mm, 5mm oder 4mm, und/oder
o) **dass** die beiden Anschlussteile (2, 3) jeweils mindestens einen Stromanschluss (5, 6) aufweisen, um den Strom einzuleiten bzw. auszuleiten, wobei die einzelnen Stromanschlüsse (5, 6) vorzugsweise jeweils mindestens eine Bohrung in dem jeweiligen Anschlussteil (2, 3) aufweisen, insbesondere jeweils zwei Bohrungen, die bezüglich der Stromflussrichtung nebeneinander angeordnet sind, und/oder
p) **dass** die einzelnen Spannungsmesskontakte (8-19; 22-25) jeweils Kontaktinseln sind, die aus einer elektrisch leitfähigen Beschichtung auf dem jeweiligen Anschlussteil (2, 3) bestehen, und/oder
q) **dass** die einzelnen Kontaktinseln jeweils im Wesentlichen rechteckig sind, und/oder
r) **dass** die Beschichtung der Kontaktinseln aus einem anderen Leitermaterial besteht als die Anschlussteile (2, 3), und/oder
s) **dass** die Kontaktinseln auf dem Strommesswiderstand (1) matrixförmig in mehreren, insbesondere vier, Reihen rechtwinklig zu der Stromflussrichtung und mehreren, insbesondere drei, Spuren parallel zu der Stromflussrichtung angeordnet sind.

13. Strommesseinrichtung mit

a) einem Strommesswiderstand (1) nach einem der vorhergehenden Ansprüche und
b) einer Spannungsmesseinrichtung (26) zur Spannungsmessung an den Spannungsmesskontakten (8-19; 22-25) des Strommesswiderstands (1) und zur Ermittlung entsprechender Spannungsmesswerte, und
c) einer Auswertungseinheit (27) zur Ermittlung des durch den Strommesswiderstand (1) fließenden Stroms (I) aus den Spannungsmesswerten.

14. Strommesseinrichtung nach Anspruch 13,
**dadurch gekennzeichnet,**

a) **dass** die Spannungsmesskontakte (8-19; 22-25) eine Wheatstonesche Messbrücke bilden, und/oder
b) **dass** die Spannungsmesskontakte (8-19; 22-25) mehrere redundante Strommesskanäle bilden.

**Claims**

1. Current-sensing resistor (1) for measuring an electric current (I), having

   a) a first connection part (2) made of a conductor material for introducing the electric current (I) to be measured into the current-sensing resistor (1),
   b) a second connection part (3) made of a conductor material for discharging the electric current (I) to be measured from the current-sensing resistor (1),
   c) a resistor element (4) made of a resistor material, the resistor element (4) being arranged in the direction of current flow between the first connection part (2) and the second connection part (3) so that the current (I) to be measured flows through the resistor element (4), and
   d) at least one pair of voltage-sensing contacts (8-19; 22-25) for measuring a voltage drop across the resistor element (4), the voltage-sensing contacts (8-19; 22-25) each engaging one of the connection parts (2, 3), and
   e) at least one incision (20; 20.1-20.4) in at least one of the connection parts (2, 3), the incision (20; 20.1-20.4) surrounding one of the voltage-sensing contacts (8-19; 22-25) and preventing a current flow across the incision (20; 20.1-20.4),
   **characterized in**
   f) **that** a plurality of pairs of voltage-sensing contacts (8-19; 22-25) are arranged one behind the other in the direction of current flow, and
   g) **that** the incision (20; 20.1-20.4) and the voltage-sensing contact (14) surrounded by the incision (20; 20.1-20.4) are arranged centrally in the connection part (2) with respect to the position transverse to the current flow direction.

2. Current-sensing resistor (1) according to claim 1,
   **characterized in**

   a) **that** the current-sensing resistor (1) has a certain center axis (7) parallel to the current flow direction,
   b) **that** the connection part (2) with the incision (20.1) has a certain width (B) transverse to the current flow direction, and
   c) **that** the voltage-sensing contact (10) surrounded by the incision (20.1) has an eccentricity (e) relative to the center axis (7) of the current-sensing resistor (1) which is smaller than 50%, 40%, 30%, 20%, 10% or 5% of the width (B) of the current-sensing resistor (1).

3. Current-sensing resistor (1) according to one of the preceding claims,
   **characterized in**

   a) **that** the connection part with the incision (20; 20.1-20.4) has a certain width (B) transverse to the current flow direction, and
   b) **that** the incision (20; 20.1-20.4) in the connection part extends transversely to the current flow direction over at most 60%, 50% or 40% of the width (B) of the connection part (2, 3).

4. Current-sensing resistor (1) according to one of the preceding claims,
   **characterized in**

   a) **that** the incision (20; 20.1-20.4) is arcuate, in particular U-shaped or V-shaped, with a base transverse to the current flow direction and legs facing the resistor element (4) parallel to the current flow direction, and/or
   b) **that** the legs of the incision (20; 20.1-20.4) have a width ($b_s$) perpendicular to the current flow direction which is at least as large as the thickness (h) of the resistor element (4), and/or
   c) **that** the base of the incision (20; 20.1-20.4) has a width ($l_s$) parallel to the current flow direction which is at least as large as the thickness (h) of the resistor element (4).

5. Current-sensing resistor (1) according to claim 4,
   **characterized in**

   a) **that** the legs of the incision (20; 20.1-20.4) project in the current flow direction into the resistor element (4) and end in the resistor element (4), in particular with a leg length (dl) within the resistor element (4) of

       a1) 6mm with a maximum deviation of ±3mm, ±2mm, ±1mm, ±0.5mm or ±0.2mm, and/or
       a2) 10%-90%, 20%-80% or 30%-70% of the length ($l_{RM}$) of the resistor element (4) in the current flow direction, and/or

   b) **that** the legs of the incision (20; 20.1-20.4) end in the connection part (2, 3) in front of the resistor element (4) in the current flow direction, in particular with a leg length of

       b1) 4mm with a maximum deviation of ±2mm, ±1mm, ±0.5mm or ±0.2mm, and/or
       b2) 10%-90%, 20%-80%, 30%-70% of the width of the current-sensing resistor (1), or

   c) **that** the legs of the incision (20; 20.1-20.4) end in the direction of current flow at the boundary between the resistor element (4) and the connection part (2, 3).

6. Current-sensing resistor (1) according to one of the preceding claims, **characterized in that** the incision (20; 20.1-20.4) in the connection part (2, 3) delimits a contact island, the contact island between the incision (20; 20.1-20.4) and the resistor element (4) having an area of at least 4mm$^2$, 5mm$^2$, 6mm$^2$, 8mm$^2$ or 10mm$^2$.

7. Current-sensing resistor (1) according to one of the preceding claims, **characterized in**

    a) **that** at least one incision (20.1-20.4) is arranged in each of the two connection parts (2, 3), which incision (20.1-20.4) surrounds a contact island for a voltage-sensing contact (9, 10, 23, 24), and
    b) **that** the incisions (20.1-20.4) are arranged in pairs on opposite sides of the resistor element (4) in the connection parts (2, 3), namely in the same late-running position with respect to the central axis (7) of the current-sensing resistor (1).

8. Current-sensing resistor (1) according to one of the preceding claims, **characterized in that** in at least one of the two connection parts (2, 3) a plurality of incisions (20.1-20.4) are arranged next to one another with respect to the direction of current flow, which incisions each surround a contact island for a voltage-sensing contact (9, 10, 23, 24).

9. Current-sensing resistor (1) according to one of the preceding claims, **characterized in**

    a) **that** the resistor element (4) is divided into a first part and a second part, so that the current (I) to be measured is divided into a first current path through the first part and a second current path through the second part of the resistor element (4),
    b) **that** a cutout (21) is provided in the resistor element (4) which prevents current flowing across the cutout (21), so that the two current paths run on either side of the cutout (21),
    c) **that** the cutout (21) extends in the direction of current flow preferably over the entire length of the resistor element (4),
    d) **that** the cutout (21) preferably extends in the direction of current flow into the connection parts (2, 3).

10. Current-sensing resistor (1) according to claim 9,

**characterized in**

    a) **that** in the first current path in each case a plurality of voltage-sensing contacts (8-19; 22-25) are arranged one behind the other along the direction of current flow,
    b) **that** in the second current path in each case a plurality of voltage-sensing contacts (8-19; 22-25) are arranged one behind the other along the current flow direction, and
    c) **that** a pair of voltage-sensing contacts (8-19; 22-25) engages on the two parts of the resistor element (4), in particular in the connection parts directly at the boundary to the resistor element (4), in order to measure the voltage drop between the two parts of the resistor element (4) transversely to the current flow direction.

11. Current-sensing resistor (1) according to claim 9 or 10, **characterized in**

    a) **that** in the first current path in each case a plurality of voltage-sensing contacts (8-19; 22-25) are arranged side by side transversely to the direction of current flow,
    b) **that** in the second current path in each case a plurality of voltage-sensing contacts (8-19; 22-25) are arranged side by side transversely with respect to the current flow direction, and
    c) **that** in each case a plurality of voltage-sensing contacts (8-19; 22-25) are arranged on the two parts of the resistor element (4), namely transversely to the current flow direction next to one another, in particular in the connection parts (2, 3) directly at the boundary to the resistor element (4),

12. Current-sensing resistor (1) according to one of the preceding claims, **characterized in**

    a) **that** the conductor material is copper, a copper alloy, aluminum or an aluminum alloy, and/or
    b) **that** the conductor material of the connection parts (2, 3) has a smaller specific electrical resistance than the resistance material of the resistor element (4), and/or
    c) **that** the resistance material of the resistor element (4) is one of the following alloys:

        c1) a copper alloy, in particular a copper-manganese-tin alloy, in particular CuMn12-Ni2 or CuMn7Sn2,3, or a copper-manganese-nickel alloy, in particular Cu84-Ni4Mn12 or Cu65Mn25Ni10, or a copper-chromium alloy,
        c2) a nickel alloy, in particular NiCr or CuNi, and/or

d) **that** the resistor element (4) is electrically and mechanically connected to the two connection parts, in particular by a welded joint, in particular by electron beam welding, and/or

e) **that** the resistance material has a specific electrical resistance which is less than $2 \cdot 10^{-4}$ $\Omega \cdot m$, $2 \cdot 10^{-5}$ $\Omega \cdot m$ or $2 \cdot 10^{-6}$ $\Omega \cdot m$, and/or

f) **that** the resistive material has an electrical resistivity greater than $2.10^{-6}$ $\Omega \cdot m$, $2 \cdot 10^{-7}$ $\Omega \cdot m$, and/or

g) **that** the conductor material has a specific electrical resistance which is smaller than $10^{-6}$ $\Omega \cdot m$ or $10^{-7}$ $\Omega \cdot m$, and/or

h) **that** the resistance is low resistance with a resistance value of at most than 1 $\mu\Omega$, 10 $\mu\Omega$, 50 $\mu\Omega$, 100 $\mu\Omega$, 500 $\mu\Omega$, 10 m$\Omega$, 5 m$\Omega$, 2 m$\Omega$ or 1 m$\Omega$, and/or

i) **that** the current-sensing resistor (1) has a current carrying capacity of at least 1A, 10A, 100A, 1kA or 5 kA, and/or

j) **that** the resistor element (4) is plate-shaped, in particular as a flat plate, and/or

k) **that** the connection parts (2, 3) are each plate-shaped, in particular as a flat plate, and/or

l) **that** the current-sensing resistor (1) has a length (L) in the current flow direction which is less than 30cm, 20cm or 10cm, and/or

m) **that** the current-sensing resistor (1) has a width (B) at right angles to the current flow direction which is smaller than 20cm, 10cm or 5cm, and/or

n) **that** the current-sensing resistor (1) has a thickness (h) which is smaller than 10mm, 5mm or 4mm, and/or

o) **that** the two connection parts (2, 3) each have at least one current connection (5, 6) for introducing and discharging the current, the individual current connections (5, 6) preferably each having at least one hole in the respective connection part (2, 3), in particular in each case two holes which are arranged next to one another with respect to the direction of current flow, and/or

p) **that** the individual voltage-sensing contacts (8-19; 22-25) are in each case contact islands which consist of an electrically conductive coating on the respective connection part (2, 3), and/or

q) **that** the individual contact islands are each essentially rectangular, and/or

r) **that** the coating of the contact islands consists of a different conductor material than the connection parts (2, 3), and/or

s) **that** the contact islands on the current-sensing resistor (1) are arranged in matrix form in a plurality of, in particular four, rows at right angles to the current flow direction and a plurality of, in particular three, tracks parallel to the current flow direction.

13. Current measuring device with

a) a current-sensing resistor (1) according to one of the preceding claims and
b) a voltage measuring device (26) for voltage measurement at the voltage-sensing contacts (8-19; 22-25) of the current-sensing resistor (1) and for determining corresponding voltage measurement values, and
c) an evaluation unit (27) for determining the current (I) flowing through the current-sensing resistor (1) from the voltage measurement values.

14. Current measuring device according to claim 13, **characterized in**

a) **that** the voltage-sensing contacts (8-19; 22-25) form a Wheatstone measuring bridge, and/or
b) **that** the voltage-sensing contacts (8-19; 22-25) form several redundant current measuring channels.

**Revendications**

1. Résistance de mesure de courant (1) pour la mesure d'un courant électrique (I), avec

a) une première pièce de raccordement (2) en un matériau conducteur pour l'introduction du courant électrique à mesurer (I) dans la résistance de mesure de courant (1),
b) une deuxième pièce de raccordement (3) en un matériau conducteur pour évacuer le courant électrique à mesurer (I) de la résistance de mesure de courant (1),
c) un élément résistif (4) en un matériau résistif, dans laquelle l'élément résistif (4) est disposé dans le sens du flux de courant entre la première pièce de raccordement (2) et la deuxième pièce de raccordement (3) de telle sorte que le courant électrique (I) à mesurer circule à travers l'élément résistif (4),
d) au moins une paire de contacts de mesure de tension (8-19 ; 22-25) pour mesurer une chute de tension au-dessus de l'élément résistif (4), dans laquelle les contacts de mesure de tension (8-19 ; 22-25) s'engageant respectivement sur l'une des pièces de raccordement (2, 3), et
e) au moins une entaille (20 ; 20.1-20.4) dans au moins une des pièces de raccordement (2, 3), dans laquelle l'entaille (20 ; 20.1-20.4) entoure un des contacts de mesure de tension (8-19 ; 22-25) et empêche un flux de courant transversalement sur l'entaille (20 ; 20.1-20.4), **caractérisée en ce**

f) plusieurs paires de contacts de mesure de tension (8-19 ; 22-25) sont disposées l'une après l'autre dans le sens du flux de courant, et

g) que l'entaille (20 ; 20.1-20.4) et le contact de mesure de tension (14) entouré par l'entaille (20 ; 20.1-20.4) dans la pièce de raccordement (2) sont disposés au centre par rapport à la position perpendiculairement à la direction de flux de courant.

2. Résistance de mesure de courant (1) selon la revendication 1, **caractérisée en ce**

a) **que** la résistance de mesure de courant (1) présente un certain axe central (7) parallèlement au sens du flux de courant,

b) **que** la pièce de raccordement (2) avec l'entaille (20.1) présente une certaine largeur (B) perpendiculairement à la direction du flux de courant, et

c) **que** le contact de mesure de tension (10) entouré par l'entaille (20.1) présente par rapport à l'axe central (7) de la résistance de mesure de courant (1) une excentricité (e) qui est inférieure à 50 %, 40 %, 30 %, 20 %, 10 % ou 5 % de la largeur (B) de la résistance de mesure de courant (1).

3. Résistance de mesure de courant (1) selon l'une quelconque des revendications précédentes, **caractérisée en ce**

a) **que** la pièce de raccordement avec l'encoche (20 ; 20.1-20.4) présente une certaine largeur (B) perpendiculairement à la direction du flux de courant, et

b) **que** l'entaille (20 ; 20.1-20.4) dans la pièce de raccordement s'étend transversalement à la direction du flux de courant sur au maximum 60 %, 50 % ou 40 % de la largeur (B) de la pièce de raccordement (2, 3).

4. Résistance de mesure de courant (1) selon l'une quelconque des revendications précédentes, **caractérisée en ce**

a) **que** l'entaille (20 ; 20.1-20.4) est en forme d'arc, en particulier en forme de U ou de V, avec une base transversalement à la direction du flux de courant et des branches qui sont tournées vers l'élément résistif (4) parallèlement dans la direction du flux de courant, et/ou

b) **que** les branches de l'entaille (20 ; 20.1-20.4) présentent une largeur ($b_s$) à angle droit par rapport à la direction du flux de courant qui est au moins aussi grande que l'épaisseur (h) de l'élément résistif (4), et/ou

c) **que** la base de l'incision (20 ; 20.1-20.4) présente une largeur ($l_s$) parallèlement à la direction du flux de courant qui est au moins aussi grande que l'épaisseur (h) de l'élément résistif (4).

5. Résistance de mesure de courant (1) selon la revendication 4, **caractérisée en ce**

a) **que** les branches de l'entaille (20 ; 20.1-20.4) dépassent dans le sens du flux de courant jusqu'à l'élément résistif (4) et se terminent dans l'élément résistif (4), en particulier avec une longueur de branche (dl) à l'intérieur de l'élément résistif (4) de

a1) 6 mm avec un écart maximal de $\pm 3$ mm, $\pm 2$ mm, $\pm 1$ mm, $\pm 0,5$ mm ou $\pm 0,2$ mm, et/ou

a2) 10 %-90 %, 20 %-80 % ou 30 %-70 % de la longueur ($1_{RM}$) de l'élément résistif (4) dans le sens du flux de courant, et/ou

b) **que** les branches de l'entaille (20 ; 20.1-20.4) se terminent dans le sens du flux de courant devant l'élément résistif (4) dans la pièce de raccordement (2, 3), en particulier avec une longueur de branche de

b1) 4 mm avec un écart maximal de $\pm 2$ mm, $\pm 1$ mm, $\pm 0,5$ mm ou $\pm 0,2$ mm, et/ou

b2) 10 %-90 %, 20 %-80 %, 30 %-70 % de la largeur de la résistance de mesure du courant (1), ou

c) **que** les branches de l'incision (20 ; 20.1-20.4) se terminent dans le sens du flux de courant sur la limite entre l'élément résistif (4) et la pièce de raccordement (2, 3).

6. Résistance de mesure de courant (1) selon l'une quelconque des revendications précédentes, **caractérisée en ce que** l'entaille (20 ; 20.1-20.4) dans la pièce de raccordement (2, 3) limite un îlot de contact, dans laquelle l'îlot de contact présente une surface d'au moins 4 mm², 5 mm², 6 mm², 8 mm² ou 10 mm² entre l'entaille (20 ; 20.1-20.4) et l'élément résistif (4).

7. Résistance de mesure de courant (1) selon l'une quelconque des revendications précédentes, **caractérisée en ce**

a) **qu'**au moins une entaille (20.1-20.4) est disposée dans chacune des deux pièces de raccordement (2, 3), qui entoure un îlot de contact pour un contact de mesure de tension (9, 10, 23, 24), et

b) **que** les entailles (20.1-20.4) sont disposées par paires sur des côtés opposés de l'élément résistif (4) dans les pièces de raccordement (2, 3) et ce, dans la même position latérale par rapport à l'axe central (7) de la résistance de mesure de courant (1).

8. Résistance de mesure de courant (1) selon l'une quelconque des revendications précédentes, **caractérisée en ce que** plusieurs entailles (20.1-20.4) sont disposées côte à côte dans au moins une des deux pièces de raccordement (2, 3) par rapport au sens du flux de courant, qui entourent chacune un îlot de contact pour un contact de mesure de tension (9, 10, 23, 24).

9. Résistance de mesure de courant (1) selon l'une quelconque des revendications précédentes, **caractérisée en ce**

   a) **que** l'élément résistif (4) est divisé en une première partie et une deuxième partie de telle sorte que le courant à mesurer (I) est divisé en un premier trajet de courant par la première partie et un deuxième trajet de courant par la deuxième partie de l'élément résistif (4),
   b) **qu'**un évidement (21) est prévu dans l'élément résistif (4), qui empêche un flux de courant transversalement au-dessus de l'évidement (21), de telle sorte que les deux chemins de courant s'étendent des deux côtés de l'évidement (21),
   c) **que** l'évidement (21) s'étend de préférence dans le sens du flux de courant sur toute la longueur de l'élément résistif (4),
   d) **que** l'évidement (21) s'étend de préférence dans le sens du flux de courant jusque dans les pièces de raccordement (2, 3).

10. Résistance de mesure de courant (1) selon la revendication 9,
    **caractérisée en ce**

    a) **que** plusieurs contacts de mesure de tension (8-19 ; 22-25) sont disposés respectivement dans le premier chemin de courant et ce, l'un après l'autre le long du sens du flux de courant,
    b) **que** plusieurs contacts de mesure de tension (8-19 ; 22-25) sont disposés respectivement dans le deuxième chemin de courant et ce, l'un après l'autre le long du sens du flux de courant, et
    c) **qu'**une paire de contacts de mesure de tension (8-19 ; 22-25) s'engage sur les deux parties de l'élément résistif (4), en particulier dans les pièces de raccordement directement à la limite de l'élément résistif (4), pour mesurer la chute de tension entre les deux parties de l'élément résistif (4) transversalement à la direction du flux de courant.

11. Résistance de mesure de courant (1) selon la revendication 9 ou 10,
    **caractérisée en ce**

    a) **que** sont disposés côte à côte dans le premier chemin de courant, plusieurs contacts de mesure de tension (8-19 ; 22-25) et ce, transversalement au sens du flux de courant,
    b) **que** sont disposés côte à côte dans le deuxième chemin de courant, plusieurs contacts de mesure de tension (8-19 ; 22-25), et ce transversalement au sens du flux de courant, et
    c) **que** plusieurs contacts de mesure de tension (8-19 ; 22-25) sont disposés côte à côte respectivement sur les deux parties de l'élément résistif (4) et ce, transversalement par rapport au sens du flux de courant, en particulier dans les pièces de raccordement (2, 3) directement à la limite de l'élément résistif (4),

12. Résistance de mesure de courant (1) selon l'une quelconque des revendications précédentes,
    **caractérisée en ce**

    a) que le matériau conducteur est du cuivre, un alliage de cuivre, de l'aluminium ou un alliage d'aluminium, et/ou
    b) que le matériau conducteur des pièces de raccordement (2, 3) présente une résistance électrique spécifique plus petite que le matériau résistif de l'élément résistif (4), et/ou
    c) que le matériau résistif de l'élément résistif (4) est un des alliages suivants :

       c1) un alliage de cuivre, en particulier un alliage cuivre-manganèse-nickel, en particulier CuMn12Ni2 ou CuMn7Sn2,3, ou un alliage cuivre-manganèse-nickel, en particulier Cu84Ni4Mn12 ou Cu65Mn25Ni10, ou un alliage cuivre-chrome,
       c2) un alliage de nickel, en particulier NiCr ou CuNi, et/ou

    d) que l'élément résistif (4) est relié électriquement et mécaniquement aux deux pièces de raccordement, en particulier par une liaison soudée, en particulier par un soudage par faisceau d'électrons, et/ou
    e) que le matériau résistif présente une résistance électrique spécifique qui est inférieure à $2 . 10^{-4} \ \Omega \cdot \Omega m$, $2 \cdot 10^{-5} \ \Omega \cdot m$ ou $2 \cdot 10^{-6} \cdot m$, et/ou
    f) que le matériau résistif présente une résistance électrique spécifique qui est supérieure à

$2 \cdot 10^{-6}$ Ωm ou $2 \cdot 10^{-7} \cdot$ Ωm, et/ou

g) que le matériau conducteur présente une résistance électrique spécifique qui est inférieure à $10^{-6} \cdot$ Ωm ou $10^{-7} \cdot$ Ωm, et/ou

h) que la résistance est de faible impédance avec une valeur de résistance supérieure ou égale à 1, μΩ10, μΩ50, μΩ100 μΩ, 500 μΩ, 10 mΩ, 5 mΩ, 2Ω m ou 1 mΩ, et/ou

i) que la résistance de mesure de courant (1) présente une capacité de charge de courant d'au moins 1A, 10A, 100A, 1kA ou 5 kA, et/ou

j) que l'élément résistif (4) est en forme de plaque, en particulier en tant que plaque plane, et/ou

k) que les pièces de raccordement (2, 3) sont respectivement en forme de plaque, en particulier en tant que plaque plane, et/ou

l) que la résistance de mesure de courant (1) présente dans le sens du flux de courant une longueur (L) qui est inférieure à 30 cm, 20 cm ou 10 cm, et/ou

m) que la résistance de mesure de courant (1) présente une largeur (B) qui est inférieure à 20 cm, 10 cm ou 5 cm à angle droit par rapport à la direction du flux de courant, et/ou

n) que la résistance de mesure de courant (1) présente une épaisseur (h) qui est inférieure à 10 mm, 5 mm ou 4 mm, et/ou

o) que les deux pièces de raccordement (2, 3) présentent chacune au moins un raccord électrique (5, 6) pour introduire ou évacuer le courant, dans laquelle les divers raccords électriques (5, 6) présentent de préférence chacun au moins un alésage dans la pièce de raccordement (2, 3) respective, en particulier respectivement deux alésages, qui sont disposés côte à côte par rapport au sens du flux de courant, et/ou

p) que les divers contacts de mesure de tension (8-19 ; 22-25) sont respectivement des îlots de contact qui sont constitués d'un revêtement électriquement conducteur sur la pièce de raccordement (2, 3) respective, et/ou

q) que les divers îlots de contact sont respectivement sensiblement à angle droit, et/ou

r) que le revêtement des îlots de contact est constitué d'un autre matériau conducteur que les pièces de raccordement (2, 3), et/ou

s) que les îlots de contact sur la résistance de mesure de courant (1) sont disposés en forme de matrice en plusieurs, en particulier quatre, rangées à angle droit par rapport au sens du flux de courant et plusieurs, en particulier trois, pistes parallèlement au sens du flux de courant.

13. Dispositif de mesure du courant avec

   a) une résistance de mesure de courant (1) selon l'une quelconque des revendications précédentes, et

   b) un dispositif de mesure de tension (26) pour mesurer la tension sur les contacts de mesure de tension (8-19 ; 22-25) de la résistance de mesure de courant (1) et pour déterminer des valeurs de mesure de tension correspondantes, et

   c) une unité d'évaluation (27) pour déterminer le courant circulant à travers la résistance de mesure de courant (1) (I) à partir des valeurs de tension mesurées.

14. Dispositif de mesure de courant selon la revendication 13,
   **caractérisé en ce**

   a) **que** les contacts de mesure de tension (8-19 ; 22-25) forment un pont de mesure de Wheatstone, et/ou

   b) **que** les contacts de mesure de tension (8-19 ; 22-25) forment plusieurs canaux de mesure de courant redondants.

Fig. 1A

Fig. 1B

Fig. 1C

Fig. 2

Fig. 3

Fig. 4

Fig. 5

Fig. 6

Spannungsmesseinrichtung

Spannungsmesswerte

Auswertungseinheit

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2012019784 A1
- US 2016077135 A1
- DE 102013005939 A1
- EP 0605800 A1